# EUROPEAN PATENT APPLICATION

(11) **EP 1 970 971 A1**
(43) Date of publication of application: **17.09.2008**
(21) Application number: 07020422.7
(22) Date of filing: 18.10.2007
(51) Int. Cl.: H01L 35/22, H01L 35/32, F02G 5/02

(54) **Thermoelectric converter**

(30) Priority: 15.03.2007 WO PCT/JP2007/055258
(71) Applicant: IBIDEN CO., LTD., Ogaki-shi Gifu 503-8604 (JP)
(72) Inventor: Ohno, Kazushige, Ibi-gun Gifu 501-0695 (JP)
(74) Representative: HOFFMANN EITLE

(57) **Abstract**

A thermoelectric converter is disclosed, wherein plural thermoelectric conversion modules (2) are connected in series by having p-type semiconductors (6) and n-type semiconductors (7) alternately provided in through holes of a ceramic honeycomb (8), respectively, and connecting the ends of the p-type semiconductors (6) and the ends of the n-type semiconductors (7) on both sides of the through holes.

## Description

### BACKGROUND OF THE INVENTION

### 1. Field of the Invention

The present invention relates to a thermoelectric converter using the Seebeck effect.

### 2. Description of the Related Art

When one end of a p-type semiconductor and one end of an n-type semiconductor are joined through an electrode, and this junction is set at high temperature while the other end of each of the p-type semiconductor and the n-type semiconductor is set at low temperature, an electromotive force is generated between the ends of each of the p-type semiconductor and the n-type semiconductor in accordance with the difference in temperature between the high temperature part and the low temperature part. The electromotive force generated between the ends of each of the p-type semiconductor and the n-type semiconductor is referred to as a thermoelectromotive force, and such an effect is referred to as the Seebeck effect. On the other hand, when one end of a p-type semiconductor and one end of an n-type semiconductor are joined through an electrode, and a current is caused to flow from the other ends of the p-type semiconductor and the n-type semiconductor, a difference in temperature is caused between the ends of each semiconductor. This phenomenon is referred to as the Peltier effect. Elements having these effects are collectively referred to as thermoelectric conversion elements. With respect to the Seebeck effect, the direction of current is reversed by switching the junction of the thermoelectric conversion element between high temperature and low temperature. Further, it is known that a greater electromotive force is obtained with a greater difference in temperature.

The electromotive force of each single thermoelectric conversion element is not so great. However, a thermoelectric conversion module into which a large number of such thermoelectric conversion elements are combined is a static thermoelectric converter characterized by no movable parts to cause vibration, noise, wear, etc., simple structure and high reliability, and a long service life and easy maintenance. Such a thermoelectric conversion module has one or more, usually several tens or more, thermoelectric conversion elements. The individual thermoelectric conversion elements are electrically joined in series, and are thermally arranged in parallel. The thermoelectric conversion module having such a configuration is used as a thermoelectric power generator using the Seebeck effect, extracting an electromotive force by depending on the difference between temperatures set at both ends of a thermoelectric conversion element, or as a thermoelectric temperature controller using the Peltier effect, cooling or heating one end of the thermoelectric conversion module by causing a difference in temperature by depending on the voltage applied across the thermoelectric conversion module.

Thermoelectric conversion materials can directly convert heat into electricity by the Seebeck effect or, conversely, can use electricity for heat (heating/cooling) by the Peltier effect. Thermoelectric conversion materials may be conventionally known materials for thermocouples for temperature measurement, for example, alloy or metal-alloy combinations such as Alumel/Chromel and platinum/platinum-rhodium. However, in the case where it is necessary to generate a large electromotive force or high thermal output with a small-size one, a combination of a p-type semiconductor and an n-type semiconductor is used. Thermoelectric conversion modules using semiconductors have the advantages of being able to control temperature with precision, being able to perform local cooling, being silent, being subject to no CFC controls, having a long service life and high reliability, requiring no maintenance and the like, and have been used, for example, to control the temperature of laser diodes for optical communications.

On the other hand, in recent years, it has been required to substantially reduce CO₂ emission as a measure against global warming. It greatly contributes to energy savings and CO₂ reduction to make effective use of unused thermal energy in industrial, household, and transportational fields. Accordingly, thermal power generation modules capable of directly converting thermal energy into electric energy have been developed. For example, automobile engines utilize only a little less than about 30% of energy on combustion as power, and discharge most of the rest of the energy together with exhaust gas. If an efficient thermoelectric converter is developed in such a field, it can be expected to substantially save energy and reduce CO₂ emission. Thermoelectric converters for automobiles are required to not only be small and lightweight but also have strength, resistance to vibration, flexibility in shape, durability, a wide range of operating temperatures, freedom from maintenance, a low impact on the environment and the like. In particular, resistance to vibration and flexibility in shape are performance requirements different from those for other purposes.

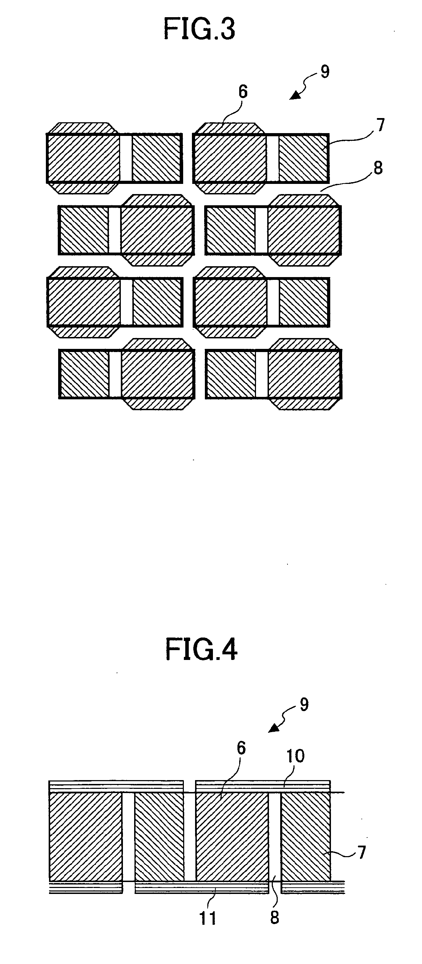

For example, FIG. 4 is a cross-sectional view showing two thermoelectric conversion elements being combined, in which a p-type semiconductor 6 and a n-type semiconductor 7 are coupled with an electrode 10 at an upper part and coupled with an electrode at a lower part on the opposite side. For example, the electrode 10 and the electrode 11 do not join the same semiconductors, but join the p-type semiconductor 6 and the n-type semiconductor 7 in series from the p-type semiconductor 6 at the left side of the drawing to the n-type semiconductor 7, then from the n-type semiconductor 7 to the p-type semiconductor 6, and then from the p-type semiconductor 6 to the n-type semiconductor 7 so that they are successively joined in series. Accordingly, FIG. 3 is a plan view showing eight thermoelectric conversion elements forming a thermoelectric conversion module. For example, in FIG. 3, the p-type semiconductor 6 and the n-type semiconductor 7 are coupled through an electrode to form a set of thermoelectric conversion elements while on the other side of the thermoelectric conversion elements (lower side, not shown), the p-type semiconductor 6 and the n-type semiconductor 7 of adjacent thermoelectric conversion elements are coupled through an electrode to form another set of thermoelectric conversion elements lower side, the first n-type semiconductor and the second p-type semiconductor are coupled through the lower electrode to form another set of thermoelectric conversion elements. That is, the p-type semiconductors 6 and the n-type semiconductors 7 are alternately coupled in series through electrodes. If a difference in temperature is caused between both sides (upper and lower sides in FIG. 4) of this thermoelectric conversion module, a predetermined electromotive force is generated across the thermoelectric conversion module based on the performance of each thermoelectric conversion element, the number of thermoelectric conversion elements coupled, and the difference in temperature between both ends of the thermoelectric conversion module.

Known semiconductors for thermoelectric conversion elements include Bi-Te system, Se-Te system, Cs-Bi-Te system, Pb-Te system, Pb-Se-Te system, Zn-Sb system, Co-Sb system, Ce-Fe-Co-Sb system, Si-Ge system and the like semiconductors. For example, a Bi-Te system thermoelectric material discovered by Goldsmid of the General Electric Company of the United States in 1954 is generally known as a thermoelectric material used in a low temperature range of normal temperature to approximately 200 °C. In general, many thermoelectric materials have a narrow range of application temperatures. Therefore, in the case of a Bi-Te system thermoelectric conversion material, a single-layer module is sufficient in a low temperature range not exceeding 200 °C. On the other hand, studies for obtaining a highly efficient thermal power generation module by combining thermoelectric materials having different ranges of application temperatures into two to three layers have been made for a middle to high temperature range exceeding 200 °C. Further, materials that perform with excellent characteristics in a middle to high temperature range have been developed. One of them is a Zn₄Sb₃ material, which is a p-type semiconductor thermoelectric material exhibiting high thermoelectric conversion performance in a middle temperature range of 200 to 400 °C. On the other hand, CoSb-based thermoelectric conversion materials can be p-type and n-type semiconductors that perform well in a middle to high temperature range of 300 to 700 °C.

However, many of these semiconductors contain hazardous metal, so that attention is required in both their manufacture and use. Recently, metal-oxide-based semiconductors have drawn attention as thermoelectric conversion element materials that are likely to clear environmental issues. For example, InO₂-SnO₂ system, (Ca, Bi)MnO₃ system, (Zn, Al)O system, Na(Co, Cu)O₄ system, NaCo₂O₄ system and the like semiconductor thermoelectric element materials have been developed for practical use.

Generally, the thermoelectric conversion module is formed of several tens or more, sometimes several hundreds or more minute semiconductor devices, which are spaced from each other to form a skeleton structure. However, as shown in Fig.3, it is accompanied by manufacturing complexity to arrange minute semiconductor devices in accordance with a desired arrangement pattern and form electrodes at both ends. Further, there is also a problem in that a completed module is mechanically weak. Several reports have been made of structures or manufacturing methods of a thermoelectric conversion module for solving these problems.

For example, there are a thermoelectric conversion module having p-type semiconductor devices and n-type semiconductor devices placed in a heat-resistant porous insulator (Patent Document 1) and a thermoelectric conversion module having p-type and n-type semiconductor devices housed in a molded substrate in which device housing holes are formed (Patent Document 2). Thermoelectric conversion modules of such configurations, where p-type and n-type semiconductor devices are provided in an insulator with through holes formed therein without using a jig for providing the semiconductor devices, are characterized by improved assembling operability, better insulation between devices, and increased mechanical strength.

Further, there have been proposed thermoelectric conversion modules where the gap between semiconductor devices is filled with an insulating material. Specifically, there are a thermoelectric conversion module where one or more pairs of a p-type semiconductor device and an n-type semiconductor device provided in a desired arrangement are embedded in an insulating material (Patent Document 3) and a thermoelectric conversion module where multiple p-type semiconductor layers and n-type semiconductor layers are stacked and air gaps are formed therein except for p-n junction parts so as to be filled with a vitreous substance (Patent Document 4). Further, there is a thermoelectric conversion module having semiconductor thermoelectric elements inserted into an insulating honeycomb structure by interposing an alkali-metal-silicate-based inorganic adhesive agent or an insulating filler made of sol-gel glass (Patent Document 5). Further, there is a highly reliable thermoelectric conversion module obtained by using a cordierite frame as a frame for a thermoelectric conversion module and controlling thermal conductivity by controlling the porosity of cordierite (Patent Document 6). These thermoelectric conversion modules, which have the air gap between semiconductor devices filled with an insulating material, are characterized by increased mechanical strength and by improved oxidation resistance and corrosion resistance of semiconductor devices. Others known as frames of thermoelectric conversion modules include low-melting glass of B₂O₃-PbO molded and used as a frame as shown in Patent Document 7, calcium silicate mechanically processed and used as a frame as shown in Patent Document 8, and silica glass formed into a lattice shape as shown in Patent Document 9.

On the other hand, metal materials such as Al and Cu are used as electrode materials for thermoelectric conversion modules. These electrode materials are joined to thermoelectric conversion elements by a method such as thermal spraying or brazing. In particular, in the case of forming electrodes by thermal spraying, it is necessary to perform thermal spraying after inserting thermoelectric conversion elements into a frame material. This is because if there is no frame, a p-type semiconductor device and an n-type semiconductor device cannot be joined or a thermal spraying material adheres to a side of a thermoelectric conversion element to electrically and thermally connect the upper and lower surfaces of the thermoelectric conversion element, thereby degrading the power generation characteristic.
[Patent Document 1] Japanese Laid-Open Patent Application No. 5-283753
[Patent Document 2] Japanese Laid-Open Patent Application No. 7-162039
[Patent Document 3] Japanese Laid-Open Patent Application No. 8-18109
[Patent Document 4] Japanese Laid-Open Patent Application No. 61-263176
[Patent Document 5] Japanese Laid-Open Patent Application No. 10-321921
[Patent Document 6] Japanese Laid-Open Patent Application No. 2005-129765
[Patent Document 7] Japanese Laid-Open Patent Application No. 8-153899
[Patent Document 8] Japanese Laid-Open Patent Application No. 11-340526
[Patent Document 9] Japanese Laid-Open Patent Application No. 2003-234516

Various kinds of thermoelectric converters have been reported as described above, and a thermoelectric converter having oxide-based semiconductors housed in a frame of a ceramic material is a possible thermoelectric converter for power recovery usable in a range of normal temperature to approximately 1000 °C, resistant to vibration, having a certain level of strength, having little effect on the environment, and easily manufacturable as an in-vehicle thermoelectric converter. However, in general, ceramic material has a weakness of being a brittle material and can be easily broken by local distortion stress such as thermal shock, mechanical shock, and vibration. Particularly, it can easily be broken by thermal distortion due to difference of thermal expansion caused by temperature difference between both sides of a honeycomb.

### SUMMARY OF THE INVENTION

According to one aspect of the present invention, there is provided a thermoelectric converter having a heat resisting property, being resistant to local distortion stress such as shock or vibration, and also being resistant to thermal distortion due to temperature difference.

According to an embodiment of the present invention, there is provided a thermoelectric converter, characterized in that plural thermoelectric conversion modules are connected in series by having p-type semiconductors and n-type semiconductors alternately provided in through holes of a ceramic honeycomb, respectively, and connecting the ends of the p-type semiconductors and the ends of the n-type semiconductors on both sides of the through holes.

### BRIEF DESCRIPTION OF THE DRAWINGS

Other objects, features and advantages of the present invention will become more apparent from the following detailed description when read in conjunction with the accompanying drawings, in which:
FIG. 1 is a diagram for illustrating a thermoelectric converter according to the present invention;
FIG. 2 is a plan view of a thermoelectric conversion module;
FIG. 3 is an enlarged view of a thermoelectric conversion module;
FIG. 4 is a cross-sectional view of thermoelectric conversion elements;
FIG. 5 is a cross-sectional view of a higher-temperature-side junction part of thermoelectric elements; and
FIG. 6 is a diagram for illustrating attachment of an in-vehicle thermoelectric converter.

### DETAILED DESCRIPTION OF THE PREFERRED EMBODIMENTS

According to a thermoelectric converter of the present invention, plural thermoelectric conversion modules are connected in series by having p-type semiconductors and n-type semiconductors alternately provided in through holes of a ceramic honeycomb, respectively, and connecting the ends of the p-type semiconductors and the ends of the n-type semiconductors on both sides of the through holes.

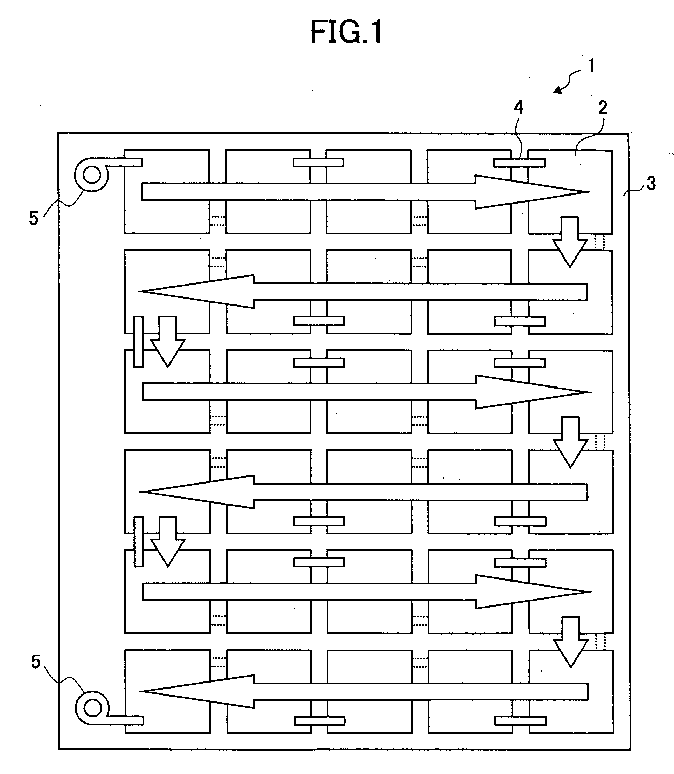

FIG. 1 is a plan view of a thermoelectric converter according to one embodiment of the present invention. It is to be noted that the arrows shown in FIG. 1 illustrate the direction of the flow of generated electric current. In the embodiment of the thermoelectric converter 1 shown in FIG. 1, a total of 30 pcs thin plate-like thermoelectric conversion modules 2 are arranged on a substrate 3 by placing horizontally 5 pcs × vertically 6 steps thermoelectric conversion modules 2 on the substrate 3. Each thermoelectric conversion module 2 is electrically connected to another thermoelectric conversion module 2 by a connection part 4 and is configured to allow electric current to flow in the direction of the arrows. It is to be noted that, in the thermoelectric converter 1, the thermoelectric conversion module 2 has one side connected to an adjacent thermoelectric conversion module 2 and another side at its bottom connected to another adjacent thermoelectric conversion module 2 at the opposite side via corresponding connection parts 4 (In the drawing, the connection part at the bottom side is illustrated with dotted lines). In other words, 30 pcs thermoelectric conversion modules 2 arranged on the substrate are electrically connected in series. Further, an electromotive force can be obtained for the thermoelectric converter 1 between the two terminals 5 shown in the left side of the drawing. Each thermoelectric conversion module 2 comprises plural thermoelectric conversion elements having a combination of the p-type semiconductor and the n-type semiconductor. In a case where one thermoelectric conversion module 2 has an electromotive force of 10 w, the thermoelectric converter 1 will have an electromotive force of 300 w.

The thermoelectric converter 1 has a temperature difference provided between the upper surface and lower surface of the thermoelectric conversion modules 2 for generating electromotive force. For example, generation of electric power can be generated with a temperature difference of approximately 300 °C by bringing the illustrated surface of the thermoelectric conversion module 2 into contact with a metal plate or an atmosphere of a good heat transfer characteristic heated to 350 °C and cooling substrate 3 side of the thermoelectric conversion module 2 (corresponding to the back side of the drawing) to 30 to 50 °C.

According to the thermoelectric converter 1 of the present invention, a ceramic honeycomb 8 is used as a frame so that the thermoelectric conversion module 2 can resist a temperature as high as approximately 1000 °C on the higher temperature side. The p-type semiconductors and the n-type semiconductors are placed in corresponding through holes of the honeycomb (each through hole of the honeycomb is also referred to as a cell). The ends of the adjacent p-type and n-type semiconductors are electrically coupled so as to be connected in series or parallel. Accordingly, each semiconductor device is connected to corresponding ends of different semiconductor devices at the higher-temperature-side end and at the lower-temperature-side end. That is, as shown in a cross-sectional view of thermoelectric conversion elements of FIG. 4, the ends of the p-type semiconductor 6 are alternately connected to corresponding ends of the n-type semiconductors 7 through the higher-temperature-side electrode 10 and a lower-temperature-side electrode 11. The ends of the p-type and n-type semiconductors 6 and 7 are connected in series in the example shown in FIG. 4.

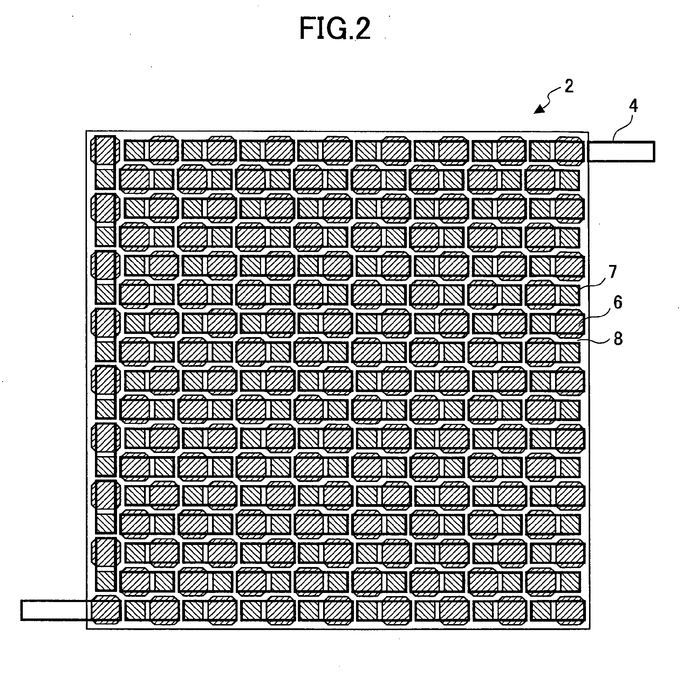

The thermoelectric conversion module according to an embodiment of the present invention is formed by placing several tens to several hundreds of such thermoelectric conversion elements into which the p-type semiconductors and the n-type semiconductors are combined. An example of the thermoelectric conversion module is shown in FIG. 2. In this example, 144 pcs (horizontally 8.5 pcs × vertically 17 steps = 144.5 pcs) thermoelectric conversion elements are placed. Further, the honeycomb has 289 pcs (17 × 17) cells. In a case where each cell has a shape of an approximate 1-mm-square and the partition wall between the cells is 0.2 mm in thickness, the thermoelectric conversion module is approximately a 21-mm-square in size. The length of a usual semiconductor thermoelectric conversion module, that is, the thickness of the thermoelectric conversion module is 1.0 to 2.0 mm. With a ceramic honeycomb structure having such a size, thermal distortion due to the difference between the thermal expansions of both sides of the honeycomb is small. Further, since the size of the thermoelectric conversion module is small and the stress applied to the entire thermoelectric converter is absorbed by the substrate supporting the thermoelectric module, the thermoelectric conversion module is less likely to break even with mechanical impact or vibrations.

In general, a large number of thermoelectric conversion elements are required to generate a large electromotive force in a thermoelectric converter. On the other hand, the length of a thermoelectric conversion element in the directions of the temperature difference, that is, the thickness of the thermoelectric converter, is required to be as small as possible in order to cause the thermoelectric conversion element to efficiently generate an electromotive force. In order to satisfy both of these requirements, a large-area, thin-plate-like thermoelectric converter is required. However, such a shape is subject to great change due to thermal expansion so that breakage is likely to occur. Further, the thermoelectric converter is also likely to break because of a bending stress or the like unless the thermoelectric converter is formed of a material having very high rigidity or flexibility. Therefore, according to the present invention, it is preferable to manufacture a thermoelectric converter that causes a desired electromotive force to be generated by connecting multiple thermoelectric conversion modules that serve as units of thermoelectric conversion and are smaller than or equal to a predetermined size. Each thermoelectric conversion module may have a predetermined size in accordance with a purpose. If the thermoelectric conversion module is smaller than or equal to a predetermined size, thermal distortion due to the difference between the thermal expansions of both sides of the thermoelectric conversion module is small, so that the thermoelectric conversion module is less likely to break even with thermal impact, mechanical impact, or vibrations. Further, strength is sufficient even with a ceramic, which is a brittle material, used as a frame. Further, a ceramic, which has heat resistance and electrical insulation, is convenient as a frame.

From the above-described aspects, in terms of a specific size of this thermoelectric conversion module, the maximum length in a cross section perpendicular to a through hole of the honeycomb is preferably less than or equal to 10 cm, and more preferably less than or equal to 5 cm in particular. The maximum length of the cross section is the length of a side in the case of a square or a rectangle or a diameter in the case of a circular shape. Usually, the shape of the cross section perpendicular to the through hole of the honeycomb is preferably a square or a rectangle approximate to a square in terms of the strength and the placement efficiency of the thermoelectric conversion module. The lower limit of the maximum length of the above-described cross section is not limited in particular, but is preferably more than or equal to 5 mm, more preferably more than or equal to 10 mm, and still more preferably more than or equal to 20 mm considering the size of a semiconductor device and the number of cells of the ceramic honeycomb. In general, a ceramic honeycomb structure of 1.0 to 2.0 mm in thickness is more likely to sustain brittle fracture in response to a bending stress if the maximum length of the above-described cross section is more than or equal to 50 mm, in particular more than or equal to 100 mm. Further, the weight increases in proportion to the size, so that a stress is likely to be applied in response to impact so as to increase the risk of breakage.

In a case where the width of each cell is determined to be 0.8 mm and the partition wall between cells is determined to be 0.2 mm in thickness based on the above-described honeycomb 100 mm square in size, the number of cells formable is 10,000 pcs (100 × 100), and the number of cells is preferably smaller than this. Usually, it is preferable that the number of cells be 100 to 2000 pcs.

The honeycomb for the thermoelectric converter according to the present invention is made of ceramic. Ceramic materials may be any materials having insulation and heat resistance, such as oxide ceramics, silicon nitride, aluminum nitride, silicon carbide, and composite materials formed of these ceramics or containing these ceramics. Of these ceramic materials, oxide ceramics are particularly preferable. Oxide ceramics are suitable materials in terms of heat resistance, insulation, strength, thermal conductivity, thermal expansibility and the like. Thermal expansibility is preferably close to that of a below-described semiconductor material that is a thermoelectric element material rather than particularly high or low. If the value of thermal conductivity and thermal expansibility of the honeycomb material are close to those of the thermoelectric element material, temperature is likely to be uniform in the internal cross section parallel to the surface of a thermoelectric conversion module when they are put in an environment of a great temperature difference as the thermoelectric conversion module, so that it is possible to reduce distortion due to thermal expansion. Preferable oxide ceramics include alumina, silica, magnesia, mullite, cordierite, aluminum titanate, titania, ceria and the like. Of these, alumina and cordierite are particularly suitable honeycomb materials.

Semiconductor materials for thermoelectric conversion elements in the thermoelectric converter of the present invention may be any materials as long as they have a thermoelectric conversion function. The thermoelectric conversion function of a semiconductor material is as follows. Since a p-type semiconductor and an n-type semiconductor generate electromotive forces of opposite polarities with the same temperature difference, by connecting the end of the p-type semiconductor and the end of the n-type semiconductor through an electrode on one side of the thermoelectric conversion module, an electromotive force that is the sum of the electromotive force of the p-type semiconductor and the electromotive force of the n-type semiconductor is obtained between the end of the p-type semiconductor and the end of the n-type semiconductor on the opposite side. Usually, these terminals on the opposite side are coupled to the terminals of corresponding adjacent thermoelectric conversion elements so as to increase the electromotive force. At this point, series coupling and parallel coupling are possible as methods of coupling adjacent thermoelectric elements. Thinking about only a theoretical electromotive force, the same electromotive force is obtained by either method, and the difference lies between collecting in high-voltage, small-current power and collecting in low-voltage, large-current power. Practically, however, internal resistance is generated in the semiconductor material when a current flows therethrough because the semiconductor material is not a conductor. In order to reduce its effect, it is preferable to reduce current flowing inside the semiconductor. For this purpose, it is preferable that the individual thermoelectric conversion elements in the thermoelectric conversion module be coupled in series. Thereby, a high-voltage, small-current electromotive force is generated.

Specific semiconductor materials include Bi-Te system, Se-Te system, Cs-Bi-Te system, Pb-Te system, Pb-Se-Te system, Zn-Sb system, Co-Sb system, Ce-Fe-Co-Sb system, Si-Ge system and the like materials as combinations of p-type and n-type semiconductors. More preferable semiconductor materials include InO₂-SnO₂ system, (Ca, Bi)Mn03 system, (Zn, Al)O system, Na(Co, Cu)O₄ system, NaCo₂O₄ system and the like materials. Particularly preferable combinations of p-type and n-type semiconductors include a combination of NaCoO₂ and ZnO, a combination of NaCoO₂ and (Ca_{0.9}Bi_{0.1}) MnO₃, a combination of Ca₃Co₄O₉ and ZnO, a combination of Ca₃Co₄O₉ and (Ca_{0.9}Bi_{0.1})MnO₃ and the like. Here, semiconductor materials are shown as Bi-Te system, ZnO, etc., which are all semiconductors, p-type or n-type semiconductors formed by doping with other elements, and are not limited to pure metals or metal compounds. For example, ZnO may be an n-type semiconductor formed by doping with Al.

In a thermoelectric converter formed by connecting multiple thermoelectric conversion modules, it is preferable that the thermoelectric conversion modules be movably connected to each other. In the thermoelectric converter according to the present invention, the thermoelectric converter having plural thermoelectric converters connected to each other generates a large electromotive force. Furthermore, each thermoelectric element is relatively small. In particular, in order to obtain a high-performance thermoelectric conversion module, it is preferable to shape the thermoelectric conversion module as a thin plate. Therefore, if these thermoelectric conversion modules are tightly fixed and connected so as not to be movable relative to each other, this results in the same condition as a single large thermoelectric converter. If the thermoelectric conversion modules are arranged on a substrate having sufficient strength and rigidity, by tightly fixing the thermoelectric conversion modules, it is possible to cause the substrate to absorb all external stress so as to prevent the stress from affecting the thermoelectric conversion modules. For this, however, the substrate should be examined in many functions for adaptation to the thermoelectric conversion modules, such as strength, rigidity, heat resistance, thermal expansibility, heat transferability, and insulation. Therefore, if the thermoelectric conversion modules are coupled so as to be movable relative to each other, each thermoelectric conversion module moves relatively to relieve a stress even if a mechanical stress or a stress due to the effect of heat is applied to the thermoelectric converter. Alternatively, a coupling member that couples the thermoelectric conversion modules in a movable manner absorbs the stress, so that a distortion stress is less easily applicable to the thermoelectric conversion modules.

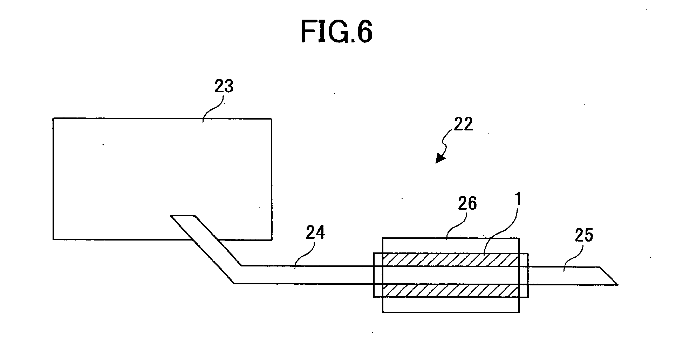

The thermoelectric converter having thermoelectric conversion modules connected to each other in a movable manner is also effective in handling and installation in a desired part. For example, it is possible to place the thermoelectric converter while deforming it in accordance with the shape of an installation location. In the case of installing the thermoelectric converter in the exhaust pipe of an automobile engine as shown in FIG. 6, the thermoelectric converter may be formed into a cylindrical shape.

The thermoelectric conversion modules may be movably connected to each other by, for example, arranging the thermoelectric conversion modules on a flexible substrate. The substrate and the thermoelectric conversion modules may be connected by any method, for example, bolting, fixation with hooks projecting from the substrate, or bonding with an adhesive agent. The materials of the substrate and a joining jig and the joining method are selected in view of the environment in which the thermoelectric conversion modules are to be used. For example, in the case of placing the substrate on the higher temperature side of the thermoelectric conversion modules, it is preferable to select a metal material that resists the service temperature of the substrate. In the case of placing the substrate on the lower temperature side of the thermoelectric conversion modules, it is also possible to select a plastic or rubber material that resists the service temperature of the substrate. Further, the substrate may not be used as a connection method, and the thermoelectric conversion modules may be connected with flexible tapes or string-like connecting members. Alternatively, the thermoelectric conversion modules may be coupled with a flexible adhesive agent. Further, it is also possible to use leads or connecting terminals for electrically connecting the thermoelectric conversion modules as flexible connection members.

A description is given of a method of manufacturing a thermoelectric converter according to the present invention, taking cordierite as an example of a ceramic honeycomb. Cordierite material powder includes Al, Si, and Mg oxides as main components, and contains 10-30% Al in terms of Al₂O₃, 40-60% Si in terms of SiO₂, and 10-30% Mg in terms of MgO when Al, Si, and Mg are converted into Al₂O₃, SiO₂, and MgO, respectively, to be 100 at% in total. Further, those in which CaO is 0-0.05%, Na₂O is 0-0.05%, K₂O is 0-0.05%, TiO₂ is 0-1%, Fe₂O₃ is 0-1%, PbO 0-1%, P₂O₅ is 0-0.2% are selectable. The inevitably mixed components such as CaO, Na₂O, K₂O, TiO₂, Fe₂O₃, PbO, and P₂O₅ are preferably less than or equal to 2.5% in total. Most of the frame after firing contains cordierite as a main component, but in some cases, the frame contains mullite or spinel.

The above-described raw material is input into a medium such as alcohol together with a molding aid to be fully mixed and crushed into slurry. Then, a green pillar honeycomb structure is made by extrusion molding. This honeycomb structure may be the same size as a thermoelectric conversion module. Usually, however, it is convenient to make a honeycomb structure greater in both cross-sectional area and length than a thermoelectric conversion module and to use it by cutting it in the process of manufacturing thermoelectric conversion modules. Further, regarding the shape of each cell of the honeycomb structure, usually, the cross-section of the cell may be a square, an equilateral hexagon, a circle, or a rectangle or octagon approximate to a square. Further, the ratio of the cross-sectional area of a p-type semiconductor to the cross-sectional area of an n-type semiconductor may be determined in accordance with the respective cross-sectional areas of the p-type and n-type semiconductors, predetermined from their respective capabilities, of a desired thermoelectric conversion module. For example, the ratio of the cross-sectional area of a p-type semiconductor to the cross-sectional area of an n-type semiconductor may be 1 : 3 to 3 : 1. This honeycomb structure is dried and degreased. The degreased honeycomb structure is cut into thin-plate-like honeycombs having a thickness corresponding to the thickness of thermoelectric conversion modules after firing. Alternatively, the cutting may be performed after insertion of semiconductor materials or after firing described below.

Predetermined semiconductor materials are inserted into corresponding cells of a plate-like honeycomb. The semiconductor materials may be in any form such as powder or slurry. In the case of slurry, re-drying is performed to remove a solvent, and the plate-like honeycomb having the semiconductor materials inserted thereinto is subjected to firing, so that a cordierite honeycomb having a semiconductor inserted into each cell is obtained. Firing may be at 1200 to 1400 °C, the same as a usual cordierite firing condition. The surfaces of this cordierite honeycomb are polished so as to smooth the fired surfaces of the semiconductors and the fired surfaces of the cordierite honeycomb. If the cordierite honeycomb has a greater shape than a desired thermoelectric conversion module, thermoelectric conversion modules are cut out from the cordierite honeycomb. For example, if the cordierite honeycomb is three times a thermoelectric conversion module on each side, the cordierite honeycomb is cut three by three so as to manufacture nine honeycombs for thermoelectric conversion modules in total.

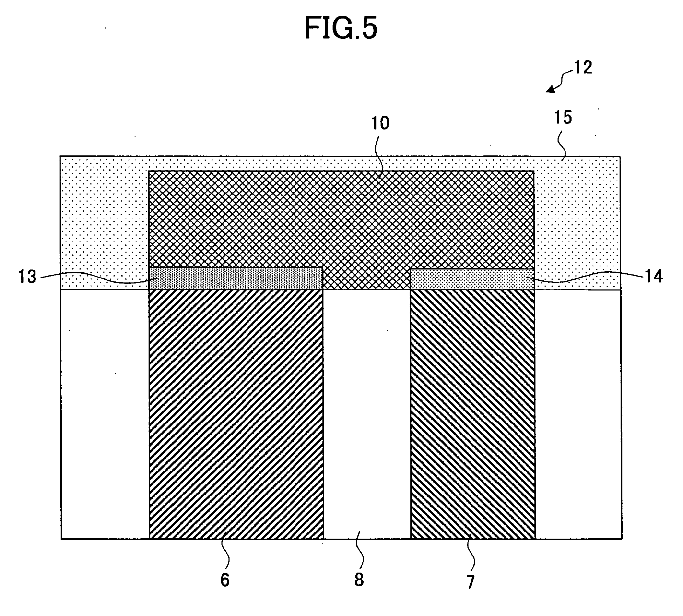

Electrodes are connected to the shaped honeycombs for thermoelectric conversion modules. FIG. 5 is a cross-sectional view showing a higher-temperature-side electrode of one of the thermoelectric conversion elements in a thermoelectric conversion module. The p-type semiconductor 6 and the n-type semiconductor 7 are coupled with the higher-temperature-side copper electrode 10. At this point, the higher-temperature-side electrode 10 is adhered to the p-type semiconductor 6 and the n-type semiconductor 7 with conductive adhesion members 13, 14. The adhesion members 13, 14 not only improve the adhesion between the higher-temperature-side electrode 10 and the p-type and n-type electrodes 6 and 7, but also prevent diffusion of their respective atoms to each other. This is because the thermoelectric conversion performance may be degraded if atoms move into or from a semiconductor to be diffused. As for the lower-temperature-side electrode, the p-type semiconductor 6 and the n-type semiconductor 7 may be coupled with the lower-temperature-side copper electrode 11 in the same manner as the higher-temperature-side electrode as shown in FIG. 4. With respect to the junction of the lower-temperature-side electrode, where temperature is low, there is no need to give much consideration to diffusion of atoms, so that there is much latitude of material choice. The electrodes may be connected by any method such as thermal spraying, transferring, coating, or bonding. In FIG. 5, although the surface of the thermoelectric conversion element including the higher-temperature-side electrode 10 is coated with an insulator 15, it is preferable to also coat the lower-temperature-side electrode with the insulator. Thereby, generated power can be prevented from leaking out.

The thermoelectric converter of the present invention can be suitably used as an in-vehicle one that utilizes automobile waste heat. For example, the thermoelectric converter of the present invention may be placed around the exhaust pipe of an automobile to generate power as shown in FIG. 6. In an in-vehicle thermoelectric converter 22 shown in FIG. 6, the higher temperature side of the thermoelectric converter 1 is placed on the side facing an exhaust pipe 24, while a cooling unit 26 of, for example, a cooling water circulation or air cooling type is provided on the lower temperature side. The thermoelectric converter 1 has plate-like thermoelectric conversion modules of approximately 30 mm square and 1 mm in thickness fixed with a thin metal plate. Since the metal plate is flexible, the metal plate absorbs vibrations of the automobile and impact so as to prevent a great mechanical stress from being applied to the thermoelectric conversion modules. Further, since the thermoelectric conversion modules have a plate shape of approximately 30 mm square, thermal stress is prevented from becoming high as well.

The thermoelectric converter of the present invention, which can extract large-capacity power from heat sources of relatively low temperatures through high temperatures, approximately 1000 °C, can be used as a power generator. In particular, the thermoelectric converter of the present invention can effectively extract electric power from automobile exhaust gas as an in-vehicle power generator, so as to be usable as a power source for motive power or auxiliary devices.

## Claims

1. A thermoelectric converter **characterized by** comprising:
a plurality of thermoelectric conversion modules (2) connected in series by having p-type semiconductors (6) and n-type semiconductors (7) alternately provided in through holes of a ceramic honeycomb (8), respectively, and connecting the ends of the p-type semiconductors (6) and the ends of the n-type semiconductors (7) on both sides of the through holes.

2. The thermoelectric converter as claimed in claim 1, **characterized in that**: the thermoelectric conversion module (2) has a maximum length in a cross section perpendicular to the through hole of the honeycomb (8) being less than or equal to 100 mm.

3. The thermoelectric converter as claimed claim 1 or 2, **characterized in that**: the ceramic honeycomb (8) includes oxide ceramics.

4. The thermoelectric converter as claimed in any one of claims 1-3, **characterized in that**: combinations of the p-type and the n-type semiconductors (6, 7) include a combination of NaCoO₂ and ZnO, a combination of NaCoO₂ and (Ca_{0.9}Bi_{0.1})MnO₃, a combination of Ca₃Co₄O₉ and ZnO, and a combination of Ca₃Co₄O₉ and (Ca_{0.9}Bi_{0.1})MnO₃.

5. The thermoelectric converter as claimed in any one of claims 1-4, **characterized in that**: the thermoelectric conversion modules (2) are movably connected to each other.

6. The thermoelectric converter as claimed in any one of claims 1-5, **characterized in that**: used for an in-vehicle thermoelectric converter utilizing automobile waste heat.
